# EUROPEAN PATENT APPLICATION

(11) **EP 4 212 959 A1**
(43) Date of publication of application: **19.07.2023**
(21) Application number: 22151090.2
(22) Date of filing: 12.01.2022
(51) Int. Cl.: G03F 7/20

(54) **TEMPERATURE STABILIZATION OF CLIMATE CHAMBER**

(71) Applicant: MYCRONIC AB, 183 03 Täby (SE)
(72) Inventor: Jonsson, Fredrik, 114 58 Stockholm (SE); Kortelainen, Raimo, 186 97 Brottby (SE)
(74) Representative: AWA Sweden AB

(57) **Abstract**

A microlithographic system (100), comprising: a climate chamber (110) enclosing an atmosphere; a printing device (120) for projection of an optical beam onto a photo-sensitive resist, the printing device being arranged in the climate chamber; a fluid reservoir (130) arranged to accommodate a thermally conductive fluid and arranged to be in thermal connection with the atmosphere to transfer heat between the atmosphere and the thermally conductive fluid; a first heat exchanging means (140) arranged outside the climate chamber; a means for transporting (150) the thermally conductive fluid between the fluid reservoir and the first heat exchanging means; and a means for supplying (160) a gas from outside the climate chamber to the enclosed atmosphere; wherein the first heat exchanging means is configured to transfer heat between the thermally conductive fluid and the gas before the gas is supplied to the enclosed atmosphere.

## Description

### TECHNICAL FIELD

The present invention generally relates to microlithographic systems, and in particular to climate control of a system for exposure of patterns onto a photo-sensitive resist.

### BACKGROUND

Systems for microlithography, components used in these systems, and processes for performing microlithography are known to be sensitive to e.g. air particles, temperature and humidity. Today these systems are normally housed within clean rooms in order to minimize the effect of these issues. It is important to control the environment for these systems in order to improve the quality of the end products.

A major problem with the climate control of microlithographic systems is that the supply of clean air to the printing devices needs to be properly tempered in order to not cause problems in the form of thermal expansion or contraction. For example, the microlithographic masks to be exposed will, if moved from an area in the production chain into another area such as the microlithographic mask writer, thermally expand or contract in shape if there is a temperature difference between the areas.

In the prior art, this has been solved by e.g. having the air supply traversing long coils of tubing of stainless steel in the clean-room environment, such that the air when it reaches the printing device is sufficiently close in temperature to the climate chamber.

However, problems still remain. For example, any fluctuations in clean-room (ambient) temperature risks to translate into fluctuations of temperature of the air entering the compartment of the printing device. Further problems with the prior art may be that it does not allow for a different temperature in the climate chamber compared to the ambient, or that the system may have to involve long coils and long distances of air transport in a usually quite costly clean-room environment. Also, the prior art does not allow for an easy/simple control of temperature, unless an exterior heater/cooler is controlled based on signals from e.g. interior thermometers.

Thus, the need for improving the systems of today, to minimize problems associated with fluctuations in temperature, still remains.

### SUMMARY

It is an object of the present invention to provide improved microlithography systems, and improved temperature control of the environment of the microlithography systems, to overcome or alleviate at least some of the drawbacks associated with the prior art techniques.

In a first aspect of the inventive concept, there is provided a microlithography system comprising a climate chamber enclosing an atmosphere. The microlithography system comprises a printing device, which is arranged in the climate chamber and configured to project an optical beam onto a photo-sensitive resist. The microlithography system further comprises a fluid reservoir, which is arranged to accommodate a thermally conductive fluid and to be in thermal connection with the atmosphere to transfer heat between the atmosphere and the thermally conductive fluid. The microlithography system further comprises a first heat exchanging means arranged outside the climate chamber, a means for transporting the thermally conductive fluid between the fluid reservoir and the first heat exchanging means, and a means for supplying a gas from outside the climate chamber to the enclosed atmosphere. The first heat exchanging means is configured to transfer heat between the thermally conductive fluid and the gas before the gas is supplied to the enclosed atmosphere.

In a second aspect, there is provided a method for adjusting the temperature of the climate in a climate chamber configured to accommodate a printing device for projection of an optical beam onto a photo-sensitive resist. The method comprises supplying a gas to a first heat exchanging means arranged outside the climate chamber. The method further comprises transferring heat between the gas and a thermally conductive fluid by the first heat exchanging means, supplying the gas to the climate chamber from the first heat exchanging means, and transferring heat between an atmosphere of the climate chamber and a fluid reservoir. According to the method, the fluid reservoir is in thermal connection with the atmosphere of the climate chamber and arranged to accommodate the thermally conductive fluid. The method further comprises transporting the thermally conductive fluid between the fluid reservoir and the first heat exchanging means.

The present inventive concept is based on the insight that by circulating a thermally conductive fluid between a fluid reservoir and a first heat exchanging means, wherein the fluid reservoir is in thermal connection with the atmosphere surrounding a printing device, a more precise temperature control may be obtained. With this arrangement, the first heat exchanging means may transfer heat between the thermally conductive fluid and the gas before the gas is supplied to the atmosphere enclosed by the climate chamber. By the term "thermal connection" it is here meant a connection, or coupling, between at least two objects, or at least two parts of the same object, which allows the transfer of thermal energy. Further, an improved thermal connection may mean that more heat can be transferred per unit of time, i.e., a higher capacity for transferring thermal energy. It is to be understood that the gas may be e.g. ambient air and/or a gas with a specific composition, and/or gas with a specific physical property such as pressure.

The fluid reservoir allows for the thermally conductive fluid to transfer heat more efficiently with the atmosphere in the climate chamber, since a large amount of the thermally conductive fluid is in thermal connection with the atmosphere. Hence, a temperature of the thermally conductive fluid, when present in the fluid reservoir, may converge towards the temperature inside the climate chamber, i.e. the air or atmosphere surrounding the printing device.

In other words, a microlithographic system according to the present inventive concept allows the thermally conductive fluid, which may have essentially the same temperature as the climate chamber after the fluid has passed through the fluid reservoir, to be transported to a first heat exchanging means where the thermally conductive fluid may exchange heat with the gas being supplied to the climate chamber, before the gas enters the atmosphere of the climate chamber. By the term "microlithographic" may be understood as relating to manufacturing processes for producing patterned thin films of materials over a substrate with features of microscopic size, such as processes used in for instance the semiconductor industry.

Thus, the temperature of the gas being supplied to the climate chamber via the first heat exchanging means may be closer to the temperature of the gas already present in the climate chamber, thus resulting in reduced temperature fluctuations inside the climate chamber. This improves the function of the microlithographic system, as it reduces the risk of thermal expansion or contraction of elements of the microlithographic system or the substrate which is being patterned. Also, this results in relaxed general requirements on the efficiency and response time of a climate control system.

Furthermore, the invention allows for an improved energy efficiency, since any heat used to elevate the temperature of the gas entering the atmosphere inside the climate chamber is taken from the climate chamber. Hence, no extra source of heating or cooling of the thermally conductive fluid is necessary, and any waste heat from devices inside the climate chamber, such as lasers, electronics or similar, can to some extent be used to equalize the gas entering the climate chamber through the first heat exchanging means.

The invention is further advantageous in that it reduces the impact of any temperature fluctuations which may occur in e.g. a surrounding clean room where the microlithographic system is arranged.

Furthermore, the invention allows the temperature to be different in the climate chamber compared to the temperature outside the climate chamber, without additional means for changing the temperature of the gas being supplied.

The invention is further advantageous in that it provides a more compact microlithographic system, since the system for managing the temperature of the climate chamber can be fully integrated with the microlithographic system.

The invention is further advantageous in that it allows the temperature inside the climate chamber to be automatically kept at a substantially constant temperature by acting as a feedback loop system which provides minor and precise adjustments of the temperature.

According to some embodiments, the microlithographic system further comprises a thermal reservoir in thermal connection with the fluid reservoir and with the climate chamber. The thermal reservoir may be a thermally stable item, allowing it to assist in maintaining the temperature of the atmosphere of the climate chamber in a stable manner and transferring heat between the atmosphere and the fluid reservoir. Further, the thermal reservoir may have a high capacity for storing heat. The thermal reservoir may be in thermal connection directly with the atmosphere of the climate chamber, and/or indirectly via a body of the climate chamber, such as an enclosure.

An advantage with using a thermal reservoir in thermal connection with the fluid reservoir and the atmosphere is that the thermally conductive fluid may more efficiently reach the temperature of the atmosphere of the climate chamber, thereby leading to an improved reduction of fluctuations in the temperature of the atmosphere in the climate chamber.

According to some embodiments, the thermal reservoir is part of the printing device or the climate chamber, which allows for an improved thermal connection between the thermal reservoir and the printing device or the climate chamber. This further allows the thermal reservoir to better adjust towards the temperature of the printing device and/or the climate chamber and its atmosphere.

According to some embodiments, the thermal reservoir comprises a body of aluminium and/or stainless steel. This is advantageous in that the thermal reservoir comprises an element with relatively high heat capacity while still being relatively cheap and easy to work with. Hence, the embodiment provides a more cost-effective system with improved heat transferring/storing capabilities.

According to some embodiments, the thermal reservoir is arranged inside the climate chamber to further improve the thermal connection with the atmosphere of the climate chamber.

According to some embodiments, the microlithographic system comprises a second heat exchanging means arranged in thermal contact with the fluid reservoir and configured to transfer heat between the atmosphere and the fluid reservoir. This is advantageous in that the heat transfer between the atmosphere of the climate chamber and the fluid reservoir is improved, thus improving the transfer of heat between the atmosphere and the thermally conductive fluid.

According to some embodiments, the second heat exchanging means is arranged inside the climate chamber to improve the thermal connection between the atmosphere and the second heat exchanging means.

According to some embodiments, the fluid reservoir is arranged inside the climate chamber to allow the thermally conductive fluid present in the fluid reservoir to better adjust towards the temperature of the atmosphere.

According to some embodiments, the gas supplied to the first heat exchanging means comprises pressurized air. In such cases, it is advantageous to first allow the gas to expand to some extent before being passed through the first heat exchanging means, as it otherwise may cool further when expanding further along its path to the exhaust into the chamber. This way,the temperature of the gas being supplied is more similar to the temperature of the atmosphere of the climate chamber.

According to some embodiments, the thermally conductive fluid is a liquid. This is advantageous in that the heat exchange may become more stable due to the inherent physical properties of liquids. Liquids are beneficially used as heat conductors, as they may have a relatively high product between the heat conductivity and heat capacity compared to other fluids. Further, liquids may generally be able to flow relatively freely in systems such as the one of present invention. This may allow the flow back and forth to the first heat exchanging means, from the fluid reservoir, to be kept at a lower flow rate, since using e.g. air would require a larger volume to be transported in order to transport the same amount of heat as a liquid would.

According to some embodiments, the microlithographic system may in addition to the first heat exchanging means further comprise a temperature-control device, configured to perform adjustments of the temperature of the gas, by at least one of increasing and lowering the temperature of the gas which is being supplied to the climate chamber. This is advantageous in that the temperature of the supplied gas may be even better tempered and more precisely adjusted to a desired temperature, such as the temperature of the enclosed atmosphere. This may be beneficial if the gas outside the climate chamber is significantly colder or warmer than the gas in the climate chamber, and the gas needs to be tempered to the temperature of the enclosed atmosphere. It is also beneficial if the temperature of the atmosphere is desired to be raised or lowered, e.g. above or below the temperature of the gas being supplied from outside the climate chamber. Also, such a minute adjustment of temperature can be used to compensate for the slight decrease of temperature of the gas which occur as it is expanded from a pressurized state into the gas pressure of the atmosphere inside the climate chamber

According to some embodiments, the microlithographic system further comprises an inlet configured to direct gas from outside the climate chamber to the first heat exchanging means, and an outlet configured to direct gas from the first heat exchanging means to the climate chamber. These embodiments may further allow the microlithographic system to comprise means for pressure reduction of the gas entering the inlet, before the gas reaches the first heat exchanging means, which is advantageous in that heat exchange may be performed at lower pressure and resulting in less thermal cooling during expansion. This may be especially advantageous when the gas entering the inlet is pressurized gas.

According to some embodiments, the first heat exchanging means is arranged at the outlet. This is advantageous in that the gas being supplied has to travel for a shorter time before it reaches the climate chamber. Hence, the risk of the gas diverging from the temperature it adjusted to in the first heat exchanging means is reduced.

According to some embodiments, heat may be exchanged between the atmosphere and at least one of a thermal reservoir and a second heat exchanging means, wherein the thermal reservoir and the second heat exchanging means are in thermal connection with the climate chamber and the fluid reservoir. The present embodiment allows the transfer of heat between the atmosphere and the thermally conductive fluid to be improved.

Further objectives of, features of, and advantages with the present invention will become apparent when studying the following detailed disclosure, the drawings, and the appended claims. Those skilled in the art realize that different features of the present invention, even if recited in different claims, can be combined in embodiments other than those described in the following.

### BRIEF DESCRIPTION OF THE DRAWINGS

This and other aspects of the present invention will now be described in more detail, with reference to the appended drawings showing embodiment(s) of the invention.
Figs. 1a-c schematically show a microlithographic system according to exemplifying embodiments of the present invention.
Figs. 2a-d schematically show a microlithographic system according to exemplifying embodiments of the present invention.
Fig. 3 schematically shows a microlithographic system according to exemplifying embodiments of the present invention.
Figs. 4a-b schematically show a microlithographic system according to exemplifying embodiments of the present invention.
Fig. 5 schematically shows a method for adjusting the climate in a climate chamber according to exemplifying embodiments of the present invention.

### DETAILED DESCRIPTION

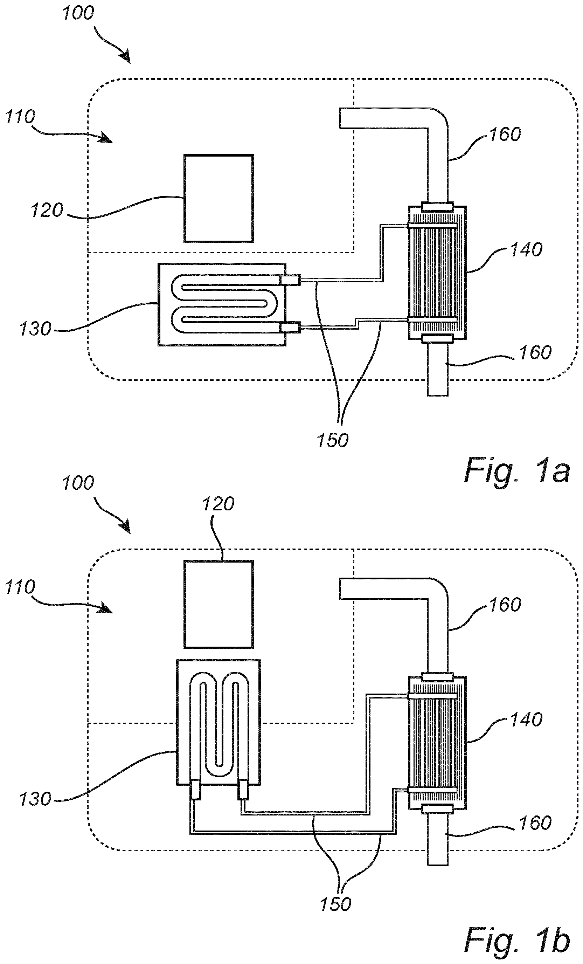

Figs. 1a-c schematically show a microlithographic system 100 comprising a climate chamber 110, wherein the climate chamber 110 has an enclosed volume, also referred to as an atmosphere. A printing device 120 for projection of an optical beam onto a photo-sensitive resist is arranged in the climate chamber 110. The microlithographic system 100 may be a photolithographic system, or any lithographic system suitable for projecting an optical beam onto a photo-sensitive resist which can create small features in microscopic scale, for example with sizes of 10 micrometres or less, and possibly even nanoscale features. Preferably, the microlithographic system 100 is suitable for use in processes relating to manufacturing of semiconductor devices.

The printing device 120 may be a mask writer for producing e.g. photo masks, wherein the masks are used for producing displays. Examples of such displays are thin-film-transistor liquid-crystal displays, TFT- LCD's, or plasma displays.

The microlithographic system 100 further comprises a fluid reservoir 130 arranged to accommodate a thermally conductive fluid. The thermally conductive fluid may be water, or another liquid, preferably with high heat capacity. The fluid reservoir 130 may comprise a body part, such as block or a plate with channels, in which the thermally conductive fluid is circulated. The fluid reservoir 130 is arranged to be in thermal connection with the atmosphere of the climate chamber 110 to transfer heat between the atmosphere and the thermally conductive fluid. It is to be understood that the printing device 120 is in thermal connection with the atmosphere of the climate chamber 110. Hence, heat generated by the printing device 120 may disperse in the atmosphere and heat may be transferred between the atmosphere and the fluid reservoir 130 since they are in thermal connection. The fluid reservoir 130 may be physically attached to the climate chamber 110. For example, the fluid reservoir 130 may be attached to a bottom plate of the climate chamber 110, either towards the interior or the exterior of the climate chamber 110.

The microlithographic system 100 further comprises a first heat exchanging means 140 arranged outside the climate chamber 110. The first heat exchanging means 140 may be a water-to-air heat exchanger. The first heat exchanging means 140 may be a single pass heat exchanger, i.e. the gas and fluid only passes through it once before moving past it. The first heat exchanging means 140 may also be a multi-pass heat exchanger. The microlithographic system 100 further comprises a means for transporting 150 the thermally conductive fluid between the fluid reservoir 130 and the first heat exchanging means 140. The means for transporting 150 may be a pipe, tube, conduit, duct, channel or anything which is suitable to transport the thermally conductive fluid. Furthermore, the microlithographic system 100 comprises means for supplying 160 a gas from outside the climate chamber 110 to the enclosed atmosphere inside the climate chamber 110. The means for supplying 160 may be a pipe, tube, conduit, duct, channel or anything which can lead air from outside the climate chamber 110 to the first heat exchanging means 140. The gas may be pressurized before being received by the means for supplying 160. For example, the gas being supplied may be pressurized externally and be supplied to the microlithographic system 100 from e.g. pressurized gas tanks.

Further, in Figs. 1a-c, the first heat exchanging means 140 is configured to transfer heat between the gas being supplied to the climate chamber 110 and the thermally conductive fluid before the gas is supplied to the enclosed atmosphere.

Since there will be a difference in leverage of heat transfer, with the thermally conductive fluid carrying a significant amount of heat compared to the gas, there is also the possibility of adding active control of the heat added or subtracted from the gas. An example of adding active control is adding Peltier elements to the means for transporting 150 the thermally conductive fluid to the first heat exchanging means 140 or using valves and diversion to heating or cooling reservoirs in order to regulate the temperatures of the gas and/or the thermally conductive fluid.

In Figs. 1a-1c, the overall configuration and organization of the climate chamber 110, the printing device 120, the first heat exchanging means 140 and the means for supplying 160 are the same in each figure. However, the arrangements of the fluid reservoir 130 in relation to the climate chamber 110 are different. It is also to be understood that the fluid reservoir 130 may abut, and/or be attached to the printing device 120 in any one of the illustrated embodiments. Hence the fluid reservoir 130 may be in thermal connection with the atmosphere, of the climate chamber 110, and/or the printing device 120.

In Fig. 1a, the fluid reservoir 130 is arranged on a bottom plate of the climate chamber 110, outside of the enclosure of the climate chamber 110, but still in thermal connection with the atmosphere of the climate chamber 110.

In Fig. 1b, the fluid reservoir 130 is arranged partially inside the climate chamber 110 and in thermal connection with the atmosphere of the climate chamber 110.

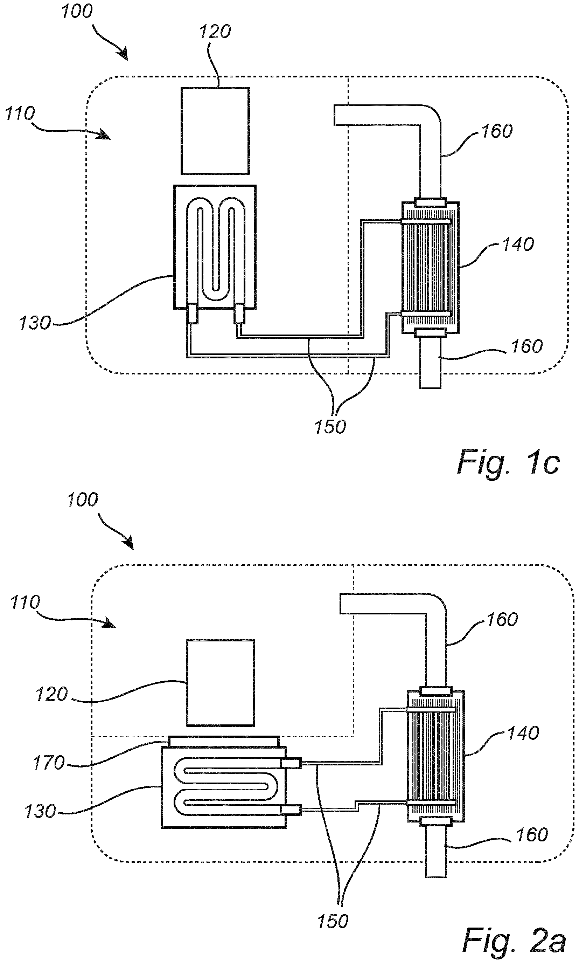

In Fig. 1c, the fluid reservoir 130 is arranged inside the climate chamber 110 and in thermal connection with the atmosphere of the climate chamber 110.

Figs. 2a-d schematically show a microlithographic system 100 similar to the microlithographic system in Figs. 1a-c. As many features of the configuration and operation of the microlithographic system 100 is substantially similar to that described in Figs. 1a-c, a detailed description of features common to the embodiment illustrated in Figs. 1a-c has been omitted for the sake of brevity and conciseness.

In Figs. 2a-d, the microlithographic system comprises a thermal reservoir 170 in thermal connection with the fluid reservoir 130, wherein the thermal reservoir 170 is in thermal connection with the climate chamber 110. The thermal reservoir 170 may be any thermally stable item capable of retaining and transferring heat. By the term "thermally stable" it is here meant that the item is capable of storing relatively large amounts of heat, and not be substantially affected by any smaller variations of the heat delivered or received in the heating or cooling of the gas passing through the heat exchanger 140. The thermal reservoir 170 may comprise a body of aluminium and/or stainless steel. However, it is to be understood that other materials may be used which is suitable for transferring and/or storing heat. The thermal reservoir 170 may comprise a solid block of metal. The thermal reservoir 170 may comprise a plurality of channels, acting as a heat exchanger while taking advantage of a thermal contact with the climate chamber, the printing device and/or the fluid reservoir 130. By the term "thermal contact" it is here meant a physical contact which allows thermal energy to be transferred via the contact.

In Fig. 2a, the thermal reservoir 170 is arranged on the enclosure of the climate chamber 110 and the fluid reservoir 130, and in thermal connection with both the atmosphere and the fluid reservoir 130. In other words, the thermal reservoir 170 may be arranged on the exterior of the enclosure of the climate chamber 110 but still be in thermal connection with the atmosphere of the climate chamber 110 and the fluid reservoir 130. The thermal reservoir 170 may a thermally stable item which facilitates the transfer of heat between the atmosphere and the thermally conductive fluid.

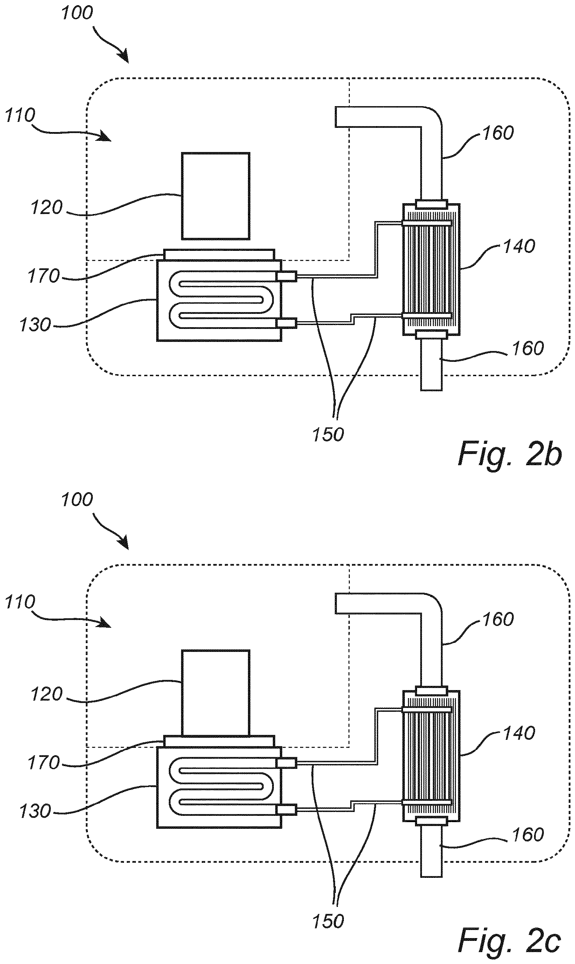

In Fig. 2b, the thermal reservoir 170 is arranged inside the climate chamber 110. It is to be understood that it may be partially arranged inside, or fully arranged inside, the climate chamber 110. The thermal reservoir 170 may also be part of the climate chamber 110, e.g. be part of an enclosure which encloses the atmosphere. The thermal reservoir 170 may be part of a bottom plate, wherein the bottom plate constitutes part of the enclosure of the atmosphere.

In Fig. 2c, the printing device 120 is arranged on the thermal reservoir 170. The thermal reservoir 170 is arranged inside the climate chamber and is in thermal connection with the printing device 120, the atmosphere and the fluid reservoir 130. The thermal reservoir 170 may be part of the printing device 120, which would allow heat to be transferred directly between the printing device 120 and the thermal reservoir 170. This could further improve the transfer of heat between the printing device 120 and the fluid reservoir 130. For example, the thermal reservoir 170 may constitute part of a bottom plate of the printing device 120. It is to be understood that the fluid reservoir 130 may also be arranged, at least partially, inside the climate chamber 110, in order to further improve the thermal connection between the fluid reservoir 130 and the atmosphere.

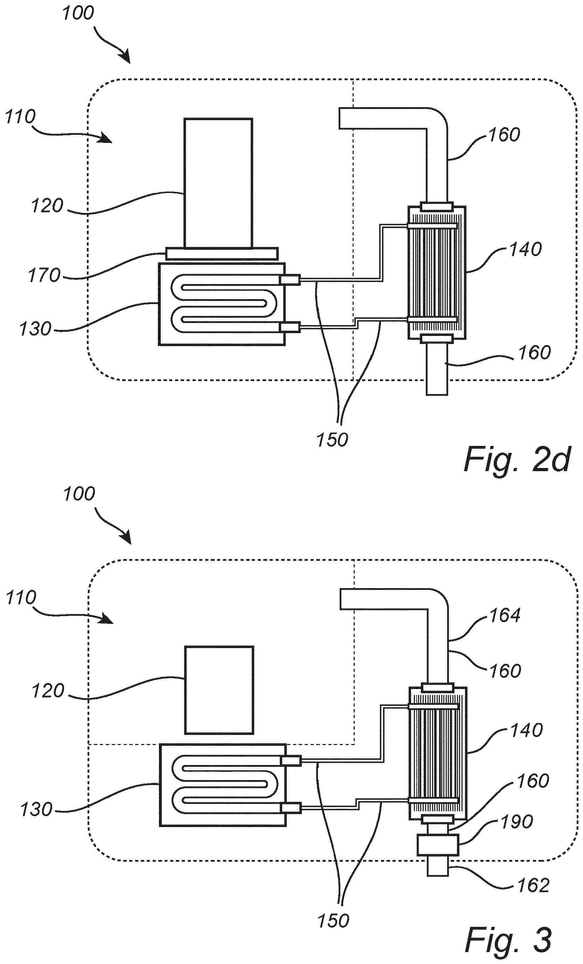

In Fig. 2d, the thermal reservoir 170 and the fluid reservoir 130 is arranged inside the climate chamber 110. The printing device 120 in Fig. 2d is arranged in the climate chamber 110 separate from the thermal reservoir 170 and fluid reservoir 130. The thermal reservoir 170 may abut the printing device 120 or be part of the printing device 120, in order to improve the transfer of heat between the printing device 120 and the fluid reservoir 130.

Fig. 3 schematically show a microlithographic system 100 similar to the microlithographic system in Fig. 1a-c. As many features of the configuration and operation of the microlithographic system 100 is substantially similar to that described in Fig. 1a-c a detailed description of features common to the embodiment illustrated in Fig. 1a-c has been omitted for the sake of brevity and conciseness.

In Fig. 3, the means for supplying 160 the gas comprises an inlet 162 and an outlet 164. The inlet 162 is configured to direct air from outside the climate chamber 110 to the first heat exchanging means 140. The outlet 164 is configured to direct air from the first heat exchanging means 140 to the climate chamber 110. Further, in Fig. 3, the microlithographic system 100 comprises means for pressure reduction 190 of the gas entering the inlet 162, before the gas reaches the first heat exchanging means 140. The means for pressure reduction 190 may be any device configured to reduce the pressure of a gas.

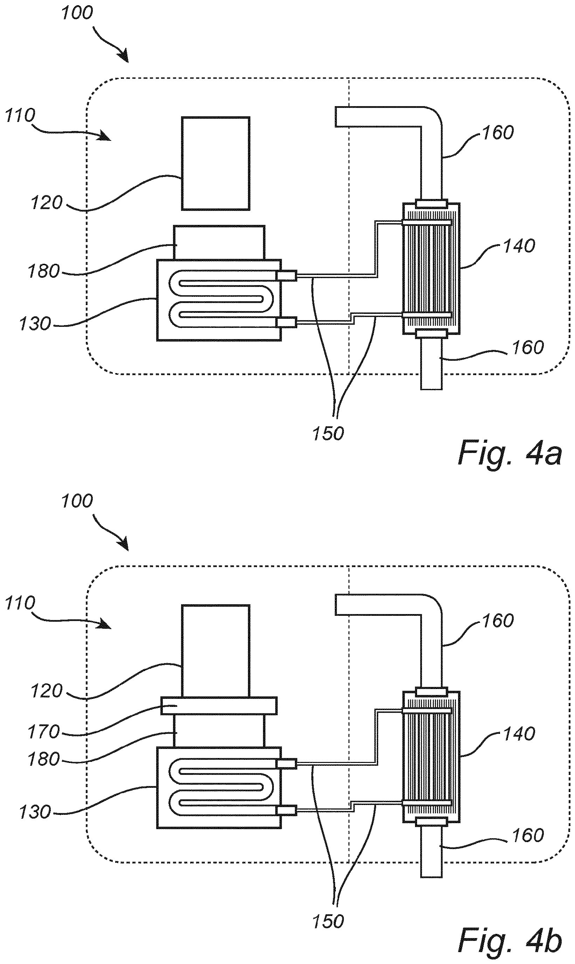

Figs. 4a-b schematically show a microlithographic system 100 similar to the microlithographic system in Figs. 1a-c. As many features of the configuration and operation of the microlithographic system 100 is substantially similar to that described in Figs. 1a-c, a detailed description of features common to the embodiment illustrated in Figs. 1a-c has been omitted for the sake of brevity and conciseness.

In Fig. 4a, the microlithographic system 100 comprises a second heat exchanging means 180 arranged in thermal connection with the fluid reservoir 130 and the thermal reservoir 170. The second heat exchanging 180 means may exchange heat similarly to the first heat exchanging means, i.e. it may be a water-to-air heat exchanger and/or a single pass heat exchanger and/or a multi-pass heat exchanger. The fluid reservoir 130 is arranged inside the climate chamber 110. It is to be understood that the fluid reservoir 130 may be arranged at least partially outside the climate chamber 110 but be in thermal connection with the second heat exchanging means 180 and/or the atmosphere of the climate chamber.

In Fig. 4b, the fluid reservoir 130 is arranged inside the climate chamber 110. Furthermore, the microlithographic system 100 comprises a thermal reservoir 170 and a second heat exchanging means 180. The second heat exchanging means 180 is arranged in thermal connection with the fluid reservoir 130 and the thermal reservoir 170. The second heat exchanging means 180 is arranged in contact with the fluid reservoir 130 and the thermal reservoir 170.

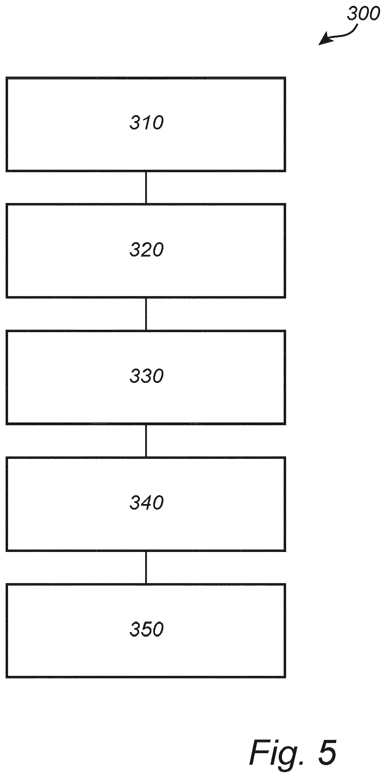

Fig. 5 schematically shows a method 300 for adjusting the climate in a climate chamber configured to accommodate a printing device for projection of an optical beam onto a photo-sensitive resist. The method 300 comprises supplying 310 a gas to a first heat exchanging means arranged outside the climate chamber, wherein heat is transferred 320 between the gas and a thermally conductive fluid by the first heat exchanging means. The gas is supplied 330 to the climate chamber from the first heat exchanging means.

The method 300 further comprises transferring 340 heat between an atmosphere of the climate chamber and fluid reservoir, wherein the fluid reservoir is in thermal connection with the atmosphere and is arranged to accommodate the thermally conductive fluid. The thermally conductive fluid is transported 350 between the fluid reservoir and the first heat exchanging means. The different steps, 310, 320, 330, 340, 350, of the method 300 may be performed simultaneously and/or in a series, and the order in which they are discussed does not limit the order in which they may be performed.

Additionally, variations to the disclosed examples can be understood and effected by the skilled person in practicing the claimed invention, from a study of the drawings, the disclosure, and the appended claims. The mere fact that certain measures are recited in mutually different dependent claims does not indicate that a combination of these measures cannot be used to advantage. For example, the fluid reservoir, the thermal reservoir and the second heat exchanging means can respectively be arranged inside the climate chamber and/or be arranged outside the climate chamber but in thermal connection with the atmosphere of the climate chamber and/or the climate chamber itself.

A feature described in relation to one aspect may also be incorporated in other aspects, and the advantage of the feature is applicable to all aspects in which it is incorporated. Other objectives, features, and advantages of the present inventive concept will appear from the detailed disclosure, from the attached claims as well as from the drawings.

Generally, all terms used in the claims are to be interpreted according to their ordinary meaning in the technical field, unless explicitly defined otherwise herein. Further, the use of terms "first", "second", and "third", and the like, herein do not denote any order, quantity, or importance, but rather are used to distinguish one element from another. All references to "a/an/the [element, device, component, means, step, etc.]" are to be interpreted openly as referring to at least one instance of said element, device, component, means, step, etc., unless explicitly stated otherwise. The steps of any method disclosed herein do not have to be performed in the exact order disclosed, unless explicitly stated.

## Claims

1. A microlithographic system (100), comprising:
a climate chamber (110) enclosing an atmosphere;
a printing device (120) for projection of an optical beam onto a photo-sensitive resist, the printing device being arranged in the climate chamber;
a fluid reservoir (130) arranged to accommodate a thermally conductive fluid and arranged to be in thermal connection with the atmosphere to transfer heat between the atmosphere and the thermally conductive fluid;
a first heat exchanging means (140) arranged outside the climate chamber;
a means for transporting (150) the thermally conductive fluid between the fluid reservoir and the first heat exchanging means; and
a means for supplying (160) a gas from outside the climate chamber to the enclosed atmosphere;
wherein the first heat exchanging means is configured to transfer heat between the thermally conductive fluid and the gas before the gas is supplied to the enclosed atmosphere.

2. The microlithographic system according to claim 1, further comprising a thermal reservoir (170) in thermal connection with the fluid reservoir, wherein the thermal reservoir is in thermal connection with the climate chamber.

3. The microlithographic system according to claim 2, wherein the thermal reservoir is part of the printing device or the climate chamber.

4. The microlithographic system according to claim 2 or 3, wherein the thermal reservoir comprises a body of at least one of aluminium and stainless steel.

5. The microlithographic system according to any one of claims 2 to 4, wherein the thermal reservoir is arranged inside the climate chamber.

6. The microlithographic system according to any one of claims 1 to 5, further comprising a second heat exchanging means (180) arranged in thermal contact with the fluid reservoir and configured to transfer heat between the atmosphere and the fluid reservoir.

7. The microlithographic system according to any one of the preceding claims, wherein the fluid reservoir is arranged inside the climate chamber.

8. The microlithographic system according to any one of the preceding claims, wherein the gas supplied to the first heat exchanging means comprises pressurized air.

9. The microlithographic system according to any one of the preceding claims, wherein the thermally conductive fluid is a liquid.

10. The microlithographic system according to any one of the preceding claims, wherein the system further comprises a temperature-control device, configured to perform at least one of increasing and lowering the temperature of the gas which is being supplied to the climate chamber.

11. The microlithographic system according to any one of the preceding claims, wherein the system further comprises
an inlet (162), configured to direct gas from outside the climate chamber to the first heat exchanging means,
an outlet (164), configured to direct gas from the first heat exchanging means to the climate chamber.

12. The microlithographic system according to claim 11, wherein the system further comprises means for pressure reduction (190) of the gas entering the inlet, before the gas reaches the first heat exchanging means.

13. The microlithographic system according to claim 11 or 12, wherein the first heat exchanging means is arranged at the outlet.

14. The microlithographic system according to anyone of the preceding claims, wherein the printing device comprises a display mask writer.

15. A method (300) for adjusting the climate in a climate chamber configured to accommodate a printing device for projection of an optical beam onto a photo-sensitive resist, comprising:
supplying (310) a gas to a first heat exchanging means arranged outside the climate chamber,
transferring (320) heat between the gas and a thermally conductive fluid by the first heat exchanging means,
supplying (330) the gas to the climate chamber from the first heat exchanging means,
transferring (340) heat between an atmosphere of the climate chamber and a fluid reservoir, wherein the fluid reservoir is in thermal connection with the atmosphere and is arranged to accommodate the thermally conductive fluid,
transporting (350) the thermally conductive fluid between the fluid reservoir and the first heat exchanging means.
